# EUROPÄISCHE PATENTSCHRIFT

(11) **EP 3 309 805 B1**
(45) Veröffentlichungstag und Bekanntmachung des Hinweises auf die Patenterteilung: **14.10.2020**
(21) Anmeldenummer: 17190761.1
(22) Anmeldetag: 13.09.2017
(51) Int. Cl.: H01H 9/18, H01H 27/00, H02G 3/14, H03K 17/94

(54) **KARTENSCHALTER**
KEYCARD SWITCH
INTERRUPTEUR A CARTE

(30) Priorität: 14.10.2016 DE 102016119608
(43) Veröffentlichungstag der Anmeldung: 18.04.2018
(73) Patentinhaber: Albrecht Jung GmbH & Co. KG, 58579 Schalksmühle (DE)
(72) Erfinder: Löhr, Stefan, 44137 Dortmund (DE); Brosowski, Mathias, 42399 Wuppertal (DE); Bonventre, Giancarlo, 58509 Lüdenscheid (DE); Haugk, Christian, 58579 Schalksmühle (DE)

(56) Entgegenhaltungen:
- EP-A1- 2 573 940
- CN-A- 101 615 522
- DE-A1-102008 063 108

## Beschreibung

Die vorliegende Erfindung geht von einem gemäß Oberbegriff des Hauptanspruches konzipierten Kartenschalter aus.

Derartige Kartenschalter sind oftmals auf Basis herkömmlicher Taster der Gebäudesystemtechnik aufgebaut. Die Betätigung des zugehörigen Tasters wird bei solchen Kartenschaltern durch das Einführen der Karte in den Führungsschlitz beziehungsweise das Herausziehen der Karte aus dem Führungsschlitz bewirkt. Beim Einführen der Karte kommt diese zunächst mit der unteren Hauptfläche an dem Betätigungsglied und mit der oberen Hauptfläche an der Innenseite des Gehäuseoberteils zur Anlage und schaltet dann beim weiteren Einführen zum Beispiel den zugehörigen Taster ein. Mit dem Herausziehen der Karte aus dem Führungsschlitz wird der zugehörige Taster zum Beispiel automatisch wieder ausgeschaltet beziehungsweise zurückgesetzt. Es sind zudem mittlerweile Kartenschalter bekannt geworden, die diese Funktionen berührungslos ausführen, wobei dann im Kartenschalter eine Sensoreinrichtung vorgesehen ist, die berührungslos das Vorhandensein der Karte erfasst. Oftmals finden solche Kartenschalter als sogenannter "Schlüsselkartenschalter" in Hotels Anwendung, wobei mit der Karte oftmals auch gleichzeitig das Schloss der Zimmertür betätigt werden kann. Nach dem Betreten des Zimmers wird die Karte vom Nutzer in den Kartenschalter eingesteckt, wodurch alle angeschlossenen elektrischen Verbraucher (Aktoren) eingeschaltet werden können. Die Karte verbleibt normalerweise im Kartenschalter, bis der Nutzer das Zimmer wieder verlässt und die Karte aus dem Kartenschalter entnimmt. Durch das Herausnehmen der Karte werden dann alle angeschlossenen elektrischen Verbraucher (Aktoren) wieder ausgeschaltet. Oftmals sind solche Karten beziehungsweise Schlüsselkarten mit empfindlichen Oberflächen, wie zum Beispiel Aufdrucken und/oder empfindlichen Funktionselementen, wie zum Beispiel Magnetstreifen, RFID-Abfrageelementen und so weiter versehen. Damit dem Nutzer ein besseres Auffinden solcher Kartenschalter ermöglicht wird, sind diese oftmals mit Beleuchtungsmitteln beziehungsweise mit einer Beleuchtungseinrichtung ausgerüstet.

Durch die EP 2 573 940 B1 ist ein dem Oberbegriff des Hauptanspruches entsprechender Kartenschalter mit einem Kartenschlitz zur Aufnahme einer einzusteckenden Karte bekannt geworden. Bei einem solchen Kartenschalter, bestehend aus einem Funktionsaufsatz, welcher über ein Steckerteil und über zwei Klemmfedern elektrisch und mechanisch mit einem Unterputzeinsatzgerät gekoppelt ist, ist im Unterputzeinsatzgerät eine Sensoreinrichtung vorhanden, welche das Vorhandensein der Karte erfasst. Im Unterputzeinsatzgerät sind zudem elektrische/elektronische Schaltmittel zur Beeinflussung zumindest eines angeschlossenen Verbrauchers (Aktors) vorhanden. Es ist außerdem im Unterputzeinsatzgerät eine Beleuchtungseinrichtung vorgesehen, um einem Nutzer durch einen hinterleuchteten Kartenschlitz die Auffindung des Kartenschalters zu erleichtern. Zudem ist im Gehäuseoberteil eine aus transparentem Material bestehende Baugruppe eingesetzt, in welche einerseits das von den Leuchtmitteln abgegebene Licht eingespeist wird und welche andererseits mit ihrem Lichtaustrittsbereich der dem Nutzer zugewandten Sichtfläche des Gehäuseoberteils zugeordnet ist. Der Funktionsaufsatz besteht aus einem mit dem Kartenschlitz versehenen Gehäuseoberteil und einem, das Steckerteil und die Klemmfedern aufweisenden Gehäuseunterteil. Eine derartige Kartenschalterbeleuchtung genügt jedoch nicht immer den gestellten Anforderungen.

Außerdem ist durch die DE 10 2008 063 108 A1 ein als Kartenschalter ausgeführtes elektrisches Installationsgerät bekannt geworden. Dieses elektrische Installationsgerät umfasst einen Gerätesockel, der in einem Installationsgehäuse befestigbar ist und frontseitig ein Schaltelement sowie eine Lichtquelle aufweist. Zudem umfasst der Gerätesockel ein frontseitig befestigtes Frontelement, das einen Einsatz mit einem Kartenschlitz aufweist, wobei eine Karte während eines Einsteckvorganges in den Kartenschlitz das Schaltelement betätigt. An dem Kartenschlitz ist zumindest ein Beleuchtungselement angeordnet, welches von der Lichtquelle ausgestrahltes Licht nutzerseitig abstrahlt.

Zudem ist durch die CN 101 615 522 A ein als Kartenschalter ausgeführtes elektrisches Installationsgerät bekannt geworden, welches zur Erkennung der eingesteckten Karte RFID-Technologie zur Anwendung bringt.

Der vorliegenden Erfindung liegt deshalb die Aufgabe zugrunde, einen beleuchteten Kartenschalter zu schaffen, welcher baukastenartig aufgebaut ist und auf einfache Art und Weise eine variantenreiche Beleuchtung des Kartenschalters ermöglicht.

Diese Aufgabe wird durch die im Hauptanspruch angegebenen Merkmale gelöst.

Bei einem solchermaßen ausgebildeten Kartenschalter ist besonders vorteilhaft, dass die für Beleuchtungsaufgaben vorgesehene Baugruppe sowohl die Führung der einzusteckenden Karte übernimmt, als auch dem Nutzer über vorhandene Federmittel eine haptische Rückmeldung gibt, ob die Karte ordnungsgemäß eingesteckt worden ist.

Weiterhin ist besonders vorteilhaft, dass ein solcher Kartenschalter modulartig aus besonders wenigen, kostengünstig herzustellenden Bauteilen beziehungsweise Baugruppen besteht.

Weitere vorteilhafte Ausgestaltungen sind in den Unteransprüchen angegeben. Anhand zweier in den Zeichnungen näher dargestellten Ausführungsbeispielen sei der erfindungsgemäße Gegenstand näher erläutert. Dabei zeigen:
- Fig. 1:: prinziphaft einen solchen Kartenschalter räumlich in Explosionsdarstellung, gemäß erstem Ausführungsbeispiel;
- Fig. 2:: prinziphaft den Funktionsaufsatz räumlich im Zusammenbau, in Zuordnung zum Unterputzeinsatzgerät, welches ebenfalls räumlich im Zusammenbau dargestellt ist, gemäß erstem Ausführungsbeispiel;
- Fig. 3:: prinziphaft den Funktionsaufsatz (erstes Ausführungsbeispiel) gemäß Figur 2 im Vollschnitt, wobei in diesen eine Karte eingesteckt ist;
- Fig. 4:: prinziphaft den Funktionsaufsatz räumlich im Zusammenbau, in Zuordnung zum Unterputzeinsatzgerät, welches ebenfalls räumlich im Zusammenbau dargestellt ist, gemäß zweitem Ausführungsbeispiel;
- Fig. 5:: prinziphaft den Funktionsaufsatz (zweites Ausführungsbeispiel) gemäß Figur 4 im Vollschnitt, wobei in diesen eine Karte eingesteckt ist.

Wie aus den Zeichnungen hervorgeht, besteht ein solcher, mit einem Kartenschlitz 1 zur Aufnahme einer einzusteckenden Karte 2 versehender Kartenschalter im Wesentlichen aus einem Funktionsaufsatz A, welcher über ein Steckerteil 3 und zwei Klemmfedern 4 elektrisch und mechanisch mit einem Unterputzeinsatzgerät E zu koppeln ist. Im Funktionsaufsatz A ist eine Sensoreinrichtung vorhanden, welche das Vorhandensein der Karte 2 erfasst und entsprechende Informationen an zumindest ein im Unterputzeinsatzgerät E vorhandenes Schaltmittel 20 weiterleitet, um angeschlossene Aktoren (Verbraucher) - der Einfachheit halber nicht dargestellt - bedarfsgerecht beeinflussen zu können. Zur Beleuchtung des Kartenschalters sind Leuchtmittel 5 vorgesehen, welche auf einer Leiterplatte 6 angeordnet sind.

Wie des Weiteren aus den Figuren hervorgeht, besteht der mit dem Kartenschlitz 1 versehene Funktionsaufsatz A aus einem Gehäuseoberteil AO und einem das Steckerteil 3 und die Klemmfedern 4 aufweisenden Gehäuseunterteil AU. Im Gehäuseunterteil AU ist die mit den Leuchtmitteln 5 bestückte Leiterplatte 6 angeordnet. Die Leuchtmittel 5 sind jeweils als LEDs ausgeführt. In das Gehäuseoberteil AO ist eine, die Kartenführung übernehmende, aus transparentem Material bestehende Baugruppe 7 eingesetzt. In diese Baugruppe 7 wird einerseits das von den Leuchtmitteln 5 abgegebene Licht eingespeist, welches andererseits einem Lichtaustrittsbereich 8 zugeführt wird. Der Lichtaustrittsbereich 8 tritt aus einer Ausnehmung 9 heraus, die in der dem Nutzer zugewandten Sichtfläche AS des Gehäuseoberteils AO vorhanden ist. Die Baugruppe 7 ist einstückig ausgeführt und weist, den Leuchtmitteln 5 zugeordnet, eine Lichteinkoppeloptik auf und ist an seinem Lichtaustrittsbereich 8 mit einer Lichtauskoppeloptik versehen. Die Leuchtmittel 5 sind auf der am Gehäuseoberteil AO festgelegten Leiterplatte 6 angeordnet. Die zu Beleuchtungszwecken vorgesehene Baugruppe 7 besteht gänzlich aus Polycarbonat und ist an mehreren Außenbereichen mit einer lichtundurchlässigen Lackschicht versehen, um den Austritt von unerwünschtem Streulicht zu vermeiden. Je nach Anwendungsfall kann die Baugruppe 7 auch aus Polymethylmethacrylat hergestellt sein. Die Leiterplatte 6 ist mit den zur Funktion notwendigen Bauteilen der Sensoreinrichtung bestückt, die zur Erkennung der eingesteckten Karte 2 notwendig sind. Da die Sensoreinrichtung auf Basis der RFID-Technologie arbeitet, sind wesentliche Bauteile als Antenneneinheit 18 und RFID-Chip 19 ausgeführt. Aus diesem Grunde weist die Karte 2 entsprechende beziehungsweise kompatibel arbeitende Bauelemente auf, welche ebenfalls auf Basis der RFID-Technologie ausgeführt sind.

Die Baugruppe 7 ist mit zwei haptische Effekte erzeugenden Federelementen 10 ausgerüstet, welche mit der vom Nutzer in den Kartenschlitz 1 einzusteckenden Karte 2 zusammenwirkt. Wurde die Karte 2 vom Nutzer vollständig in den Kartenschalter eingeschoben, so signalisieren die beiden Federelemente 10 dem Nutzer durch deutliche haptische Effekte, dass dieser die Karte 2 zur Auslösung der Funktionen ordnungsgemäß in den Kartenschalter eingesteckt hat.

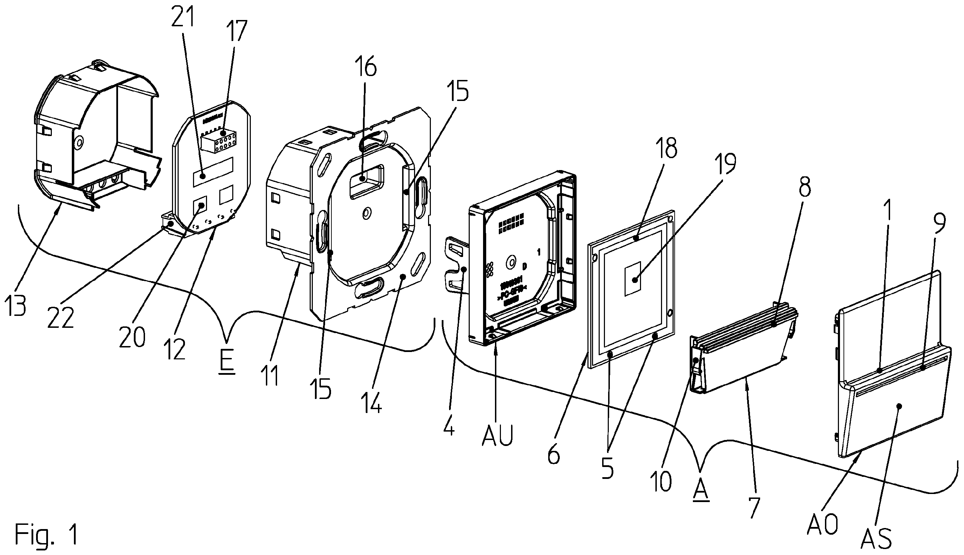

Wie insbesondere aus den Figuren 1, 3 und 5 hervorgeht, ist die Baugruppe 7 zwischen der dem Gehäuseunterteil AU abgewandten Vorderseite der Leiterplatte 6 und dem Gehäuseunterteil AU zugewandten Rückseite des Gehäuseoberteils AO haltend angeordnet. Zu diesem Zweck befindet sich im Gehäuseoberteil AO ein auf die Baugruppe 7 maßlich abgestimmter erster Aufnahmeraum 23. Zudem befindet sich im Gehäuseoberteil AO ein auf die Leiterplatte 6 abgestimmter zweiter Aufnahmeraum 24. Die Baugruppe 7 wird lediglich in den ersten Aufnahmeraum 23 eingelegt, anschließend wird die mit den Leuchtmitteln 5 versehene Leiterplatte 6 verrastend in den zweiten Aufnahmeraum 24 des Gehäuseoberteils AO eingedrückt.

Wie insbesondere aus Figur 1 hervorgeht, besteht das Unterputzeinsatzgerät E im Wesentlichen aus einem Einsatzgehäuse 11, einer Leiterplattenbaugruppe 12 und einem zum Verschließen des Einsatzgehäuses 11 vorgesehenen Deckelteil 13. Das Einsatzgehäuse 11 ist einstückig mit einem Tragring 14 versehen und weist einstückig die zum haltenden Zusammenwirken mit den Klemmfedern 4 vorgesehenen Klemmschlitze 15 auf. Zudem ist das Einsatzgehäuse 11 mit einer Aufnahmetasche 16 versehen, in welche einerseits zur Kopplung das am Gehäuseunterteil AU befindliche Steckerteil 3 und andererseits die damit zusammenwirkende, auf der Leiterplattenbaugruppe 12 angeordnete Steckbuchse 17 eingreifen. Die Leiterplattenbaugruppe 12 weist zudem zwei als Schaltrelais ausgeführte Schaltmittel 20, ein Netzteil 21 zur Energieversorgung und Anschlussklemmen 22 für die Verbindung mit einem Gebäudeinstallationssystem auf.

Da die Kartenschalter gemäß erstem Ausführungsbeispiel und gemäß zweitem Ausführungsbeispiel eine hohe Ähnlichkeit aufweisen, wurde auf eine Darstellung eines Kartenschalters gemäß zweitem Ausführungsbeispiel räumlich in Explosionsdarstellung verzichtet. Gleichwirkende Bauteile sind in den Figuren mit ein und denselben Bezugszeichen versehen.

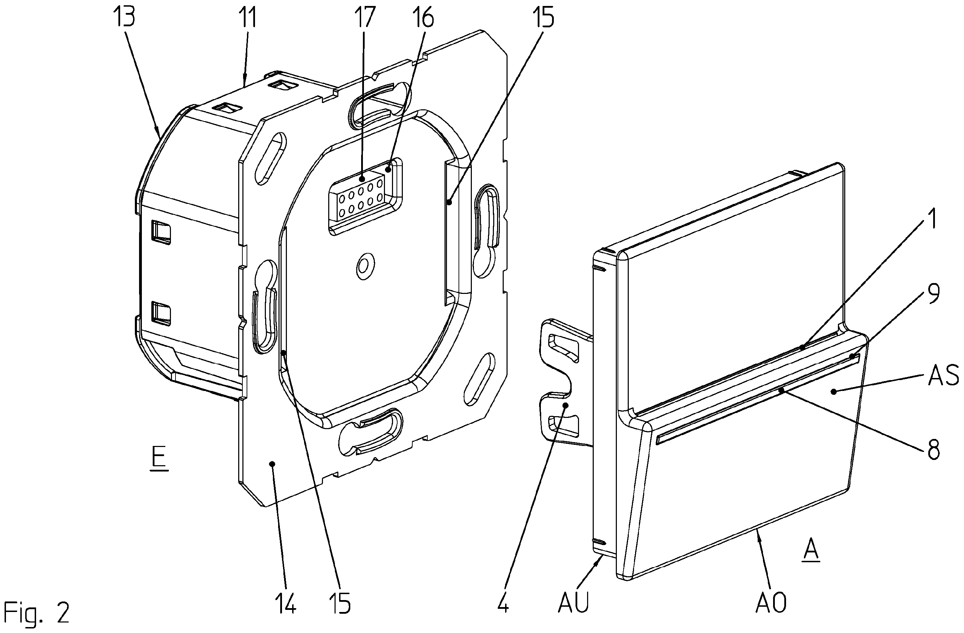

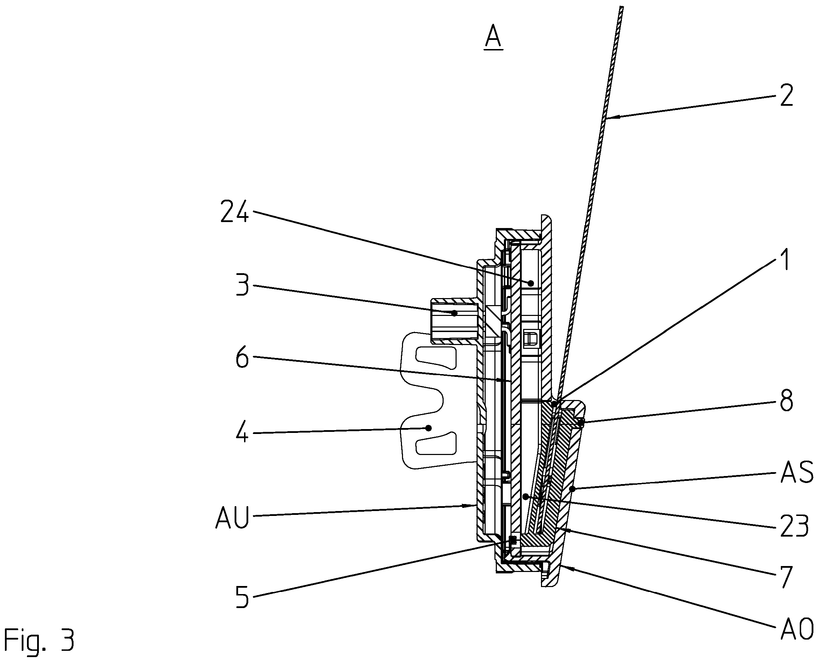

Wie insbesondere aus den Figuren 2 und 3 hervorgeht, ist gemäß erstem Ausführungsbeispiel der Lichtaustrittsbereich 8 knapp unterhalb des im Gehäuseoberteils AO befindlichen Kartenschlitzes 1, aus der dem Nutzer zugewandten Sichtfläche AS des Gehäuseoberteils AO herausgeführt. Zu diesem Zweck befindet sich in der Sichtfläche AS des Gehäuseoberteils AO eine entsprechend ausgeführte Ausnehmung 9. Weil der Lichtaustrittsbereich 8 der Baugruppe 7 rechteckförmig ausgeführt ist, weist auch die Ausnehmung 9 eine rechteckförmige Ausführung auf.

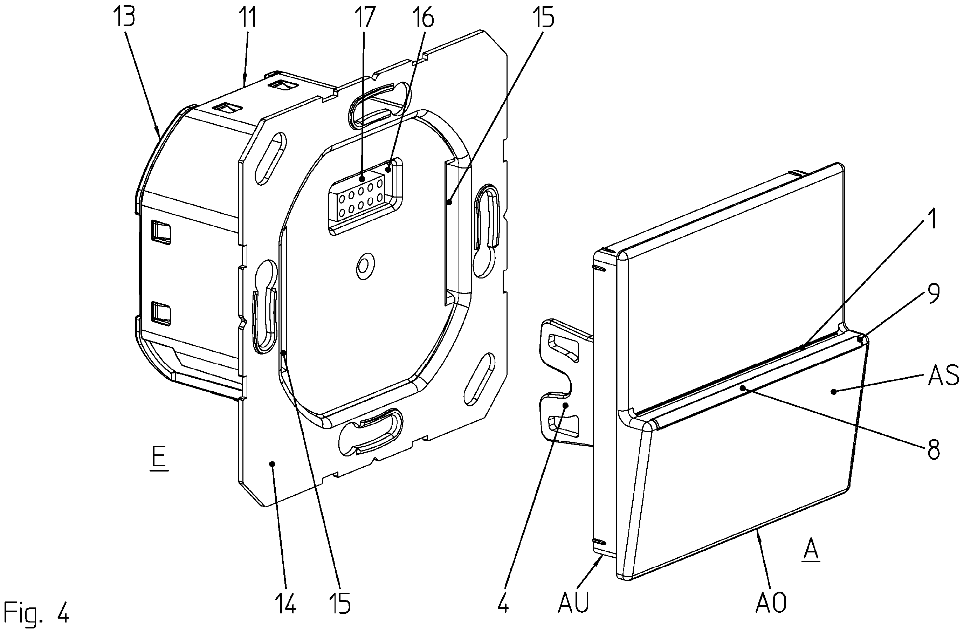

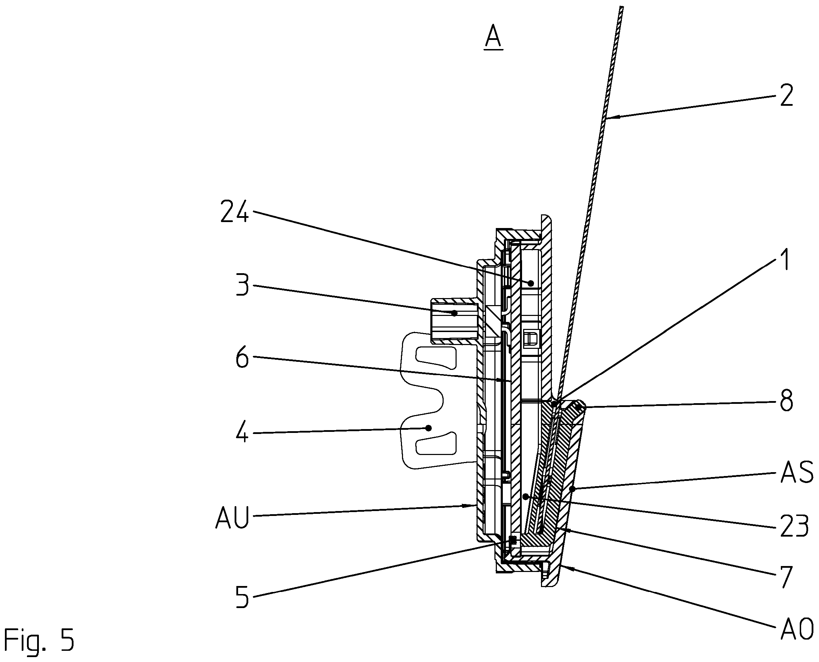

Wie insbesondere aus den Figuren 4 und 5 hervorgeht, ist gemäß zweitem Ausführungsbeispiel der Lichtaustrittsbereich 8 aus einem dem Kartenschlitz 1 zugeordneten Kantenbereich der Sichtfläche AS des Gehäuseoberteils AO herausgeführt, welche dem Nutzer zugewandt ist. Zu diesem Zweck befindet sich in diesem Kantenbereich eine entsprechend ausgeführte Ausnehmung 9. Weil der Lichtaustrittsbereich 8 der Baugruppe 7 rechteckförmig ausgeführt ist, weist auch die Ausnehmung 9 eine rechteckförmige Ausnehmung auf.

Es ist somit ein Kartenschalter geschaffen, welcher baukastenartig aufgebaut ist und auf einfache Art und Weise eine variantenreiche Beleuchtung ermöglicht. Insbesondere ist die Beleuchtung dazu vorgesehen, dass ein Nutzer den Kartenschalter besser auffindet und/oder dem Nutzer eine bestimmte Funktion angezeigt wird. Vorteilhafterweise übernimmt die für Beleuchtungsaufgaben vorgesehene Baugruppe 7 sowohl die Führung der einzusteckenden Karte 2, als auch eine haptische Rückmeldung, um dem Nutzer deutlich zu machen, ob dieser die Karte 2 ordnungsgemäß eingesteckt hat.

### Bezugszeichenliste:

- 1: Kartenschlitz
- 2: Karte
- 3: Steckerteil
- 4: Klemmfedern
- 5: Leuchtmittel
- 6: Leiterplatte
- 7: Baugruppe
- 8: Lichtaustrittsbereich
- 9: Ausnehmung
- 10: Federelemente
- 11: Einsatzgehäuse
- 12: Leiterplattenbaugruppe
- 13: Deckelteil
- 14: Tragring
- 15: Klemmschlitze
- 16: Aufnahmetasche
- 17: Steckbuchse
- 18: Antenneneinheit
- 19: RFID-Chip
- 20: Schaltmittel
- 21: Netzteil
- 22: Anschlussklemmen
- 23: Erster Aufnahmeraum
- 24: Zweiter Aufnahmeraum

- A: Funktionsaufsatz
- AO: Gehäuseoberteil
- AS: Sichtfläche
- AU: Gehäuseunterteil
- E: Unterputzeinsatzgerät

## Patentansprüche

1. Kartenschalter mit einem Kartenschlitz (1) zur Aufnahme einer einzusteckenden Karte (2), bestehend aus einem Funktionsaufsatz (A), welcher über zumindest ein Steckerteil (3) und zumindest eine Klemmfeder (4) elektrisch und mechanisch mit einem Unterputzeinsatzgerät (E) gekoppelt ist,
wobei der Funktionsaufsatz (A) aus einem mit einem Kartenschlitz (1) versehenen Gehäuseoberteil (AO) und einem das Steckerteil (3) und die Klemmfedern (4) aufweisenden Gehäuseunterteil (AU) besteht,
wobei im Funktionsaufsatz (A) und/oder im Unterputzeinsatzgerät (E) eine Sensoreinrichtung vorhanden ist, welche das Vorhandensein der Karte (2) erfasst und wobei im Funktionsaufsatz (A) und/oder im Unterputzeinsatzgerät (E) Schaltmittel (20) zur Beeinflussung zumindest eines angeschlossenen Aktors vorhanden sind und wobei im Funktionsaufsatz (A) und/oder im Unterputzeinsatz (E) Leuchtmittel (5) vorhanden sind und wobei im Gehäuseoberteil (AO) zumindest eine, aus transparentem Material bestehende Baugruppe (7) eingesetzt ist, in welche einerseits das von den Leuchtmitteln (5) abgegebene Licht eingespeist wird und welche andererseits mit ihrem Lichtaustrittsbereich (8) aus der dem Nutzer zugewandten Sichtfläche (AS) des Gehäuseoberteils (AO) austritt, **dadurch gekennzeichnet, dass** im Gehäuseunterteil (AU) eine mit Leuchtmitteln (5) bestückte Leiterplatte (6) angeordnet ist, und dass die, eine Kartenführung übernehmende, Baugruppe (7) zwischen einer dem Gehäuseunterteil (AU) abgewandten Vorderseite der Leiterplatte (6) und einer dem Gehäuseunterteil (AU) zugewandten Rückseite des Gehäuseoberteils (AO) haltend angeordnet ist, und dass die Baugruppe (7) mit zumindest einem, einen haptischen Effekt erzeugenden Federelement (10) ausgerüstet ist, welches mit der in den Kartenschlitz (1) einzusteckenden Karte (2) zusammenwirkt.

2. Kartenschalter nach Anspruch 1, **dadurch gekennzeichnet, dass** die Baugruppe (7) einteilig ausgeführt ist.

3. Kartenschalter nach Anspruch 1, **dadurch gekennzeichnet, dass** die Baugruppe (7) mehrteilig ausgeführt ist.

4. Kartenschalter nach einem der Ansprüche 1 bis 3, **dadurch gekennzeichnet, dass** die Baugruppe (7) zumindest teilweise aus Polycarbonat besteht.

5. Kartenschalter nach einem der Ansprüche 1 bis 4, **dadurch gekennzeichnet, dass** die Baugruppe (7) zumindest teilweise aus Polymethylmethacrylat besteht.

6. Kartenschalter nach einem der Ansprüche 1 bis 5, **dadurch gekennzeichnet, dass** die Baugruppe (7) mit Rastelementen ausgerüstet ist, welche haltend mit dem Gehäuseoberteil (AO) in Wirkverbindung stehen.

7. Kartenschalter nach einem der Ansprüche 1 bis 6, **dadurch gekennzeichnet, dass** die Baugruppe (7) zumindest teilweise mit einer lichtundurchlässigen Lackschicht versehen ist.

8. Kartenschalter nach einem der Ansprüche 1 bis 7, **dadurch gekennzeichnet, dass** der Lichtaustrittsbereich (8) der Baugruppe (7) zumindest teilweise rechteckförmig ausgestaltet ist.

9. Kartenschalter nach einem der Ansprüche 1 bis 8, **dadurch gekennzeichnet, dass** der Lichtaustrittsbereich (8) der Baugruppe (7) zumindest teilweise linienförmig ausgestaltet ist.

10. Kartenschalter nach einem der Ansprüche 1 bis 9, **dadurch gekennzeichnet, dass** der Lichtaustrittsbereich (8) der Baugruppe (7) zumindest teilweise kreisförmig ausgestaltet ist.

11. Kartenschalter nach einem der Ansprüche 1 bis 10, **dadurch gekennzeichnet, dass** der Lichtaustrittsbereich (8) mit zumindest einem, aus lichtundurchlässigem Material bestehenden Trennelement versehen ist.

12. Kartenschalter nach einem der Ansprüche 1 bis 11, **dadurch gekennzeichnet, dass** die mit den Leuchtmitteln (5) versehene Leiterplatte (6) verrastend mit dem Gehäuseoberteil (AO) in Wirkverbindung steht.

13. Kartenschalter nach einem der Ansprüche 1 bis 12, **dadurch gekennzeichnet, dass** zur Funktion notwendige Bauteile (18, 19) der Sensoreinrichtung zur Erkennung der Karte (2) auf der am Gehäuseoberteil (AO) festgelegten Leiterplatte (6) angeordnet sind.

14. Kartenschalter nach einem der Ansprüche 1 bis 13, **dadurch gekennzeichnet, dass** die Sensoreinrichtung auf Basis der RFID-Technologie zur Erkennung der Karte (2) datentechnisch mit dieser zusammenwirkt.

15. Kartenschalter nach einem der Ansprüche 1 bis 14, **dadurch gekennzeichnet, dass** der Lichtaustrittsbereich (8) knapp unterhalb des im Gehäuseoberteils (AO) befindlichen Kartenschlitzes (1), aus der dem Nutzer zugewandten Sichtfläche (AS) des Gehäuseoberteils (AO) heraustritt.

16. Kartenschalter nach einem der Ansprüche 1 bis 14, **dadurch gekennzeichnet, dass** der Lichtaustrittsbereich (8) aus einem dem Kartenschlitz (1) zugeordneten Kantenbereich der Sichtfläche (AS) des Gehäuseoberteils (AO) heraustritt, welche dem Nutzer zugewandt ist.

## Claims

1. Card switch with a card slot (1) for receiving a card (2) to be inserted, consisting of a functional attachment (A) which is electrically and mechanically coupled to a flush-mounted insert (E) via at least one plug part (3) and at least one clamping spring (4), wherein the functional attachment (A) consists of an upper housing part (AO) provided with a card slot (1) and a lower housing part (AU) comprising the plug part (3) and the clamping springs (4), wherein a sensor device is provided in the functional attachment (A) and/or in the flush-mounted insert (E), which sensor device detects the presence of the card (2), and wherein switching means (20) for influencing at least one connected actuator are provided in the functional attachment (A) and/or in the flush-mounted insert (E), and wherein lamps (5) are provided in the functional attachment (A) and/or in the flush-mounted insert (E), and wherein in the upper part of the housing (AO) at least one assembly (7) made of transparent material is inserted into which, on the one hand, the light emitted by the lamps (5) is fed and which, on the other hand, emerges with its light exit area (8) from the visible surface (AS) of the upper part of the housing (AO) facing the user, **characterised by the fact** that a printed circuit board (6) equipped with lamps (5) is arranged in the lower part (AU) of the housing, and by the fact that the assembly (7) which serves as card guide is arranged in a holding manner between a front side of the printed circuit board (6) facing away from the lower part (AU) of the housing and a rear side of the upper part (AO) of the housing facing the lower part (AU) of the housing, and by the fact that the assembly (7) is equipped with at least one spring element (10) which produces a haptic effect and interacts with the card (2) to be inserted into the card slot (1).

2. Card switch in accordance with Claim 1, **characterised by the fact** that the assembly (7) is designed in one piece.

3. Card switch in accordance with Claim 1, **characterised by the fact** that the assembly (7) is designed in several parts.

4. Card switch in accordance with any of Claims 1 to 3, **characterised by the fact** that the assembly (7) consists at least partially of polycarbonate.

5. Card switch in accordance with any of Claims 1 to 4, **characterised by the fact** that the assembly (7) consists at least partially of polymethyl methacrylate.

6. Card switch in accordance with any of Claims 1 to 5, **characterised by the fact** that the assembly (7) is equipped with latching elements which are in operative connection with the upper part of the housing (AO) in a retaining manner.

7. Card switch in accordance with any of Claims 1 to 6, **characterised by the fact** that the assembly (7) is at least partially provided with an opaque lacquer layer.

8. Card switch in accordance with any of Claims 1 to 7, **characterised by the fact** that the light exit area (8) of the assembly (7) is at least partially rectangular.

9. Card switch in accordance with any of Claims 1 to 8, **characterised by the fact** that the light exit area (8) of the assembly (7) is at least partially linear.

10. Card switch in accordance with any of Claims 1 to 9, **characterised by the fact** that the light exit area (8) of the assembly (7) is at least partially circular.

11. Card switch in accordance with any of Claims 1 to 10, **characterised by the fact** that the light exit area (8) is provided with at least one separating element consisting of opaque material.

12. Card switch in accordance with any of Claims 1 to 11, **characterised by the fact** that the printed circuit board (6) provided with the lamps (5) is in operative connection with the upper part of the housing (AO) in a latching manner.

13. Card switch in accordance with any of Claims 1 to 12, **characterised by the fact** that components (18, 19) of the sensor device for recognition of the card (2) necessary for the function are arranged on the printed circuit board (6) fixed to the upper part (AO) of the housing.

14. Card switch in accordance with any of Claims 1 to 13, **characterised by the fact** that the sensor device based on RFID technology for recognition of the card (2) interacts with the latter in terms of data technology.

15. Card switch in accordance with any of Claims 1 to 14, **characterised by the fact** that the light exit area (8) emerges from the visible surface (AS) of the housing upper part (AO) facing the user just below the card slot (1) located in the housing upper part (AO).

16. Card switch in accordance with any of Claims 1 to 14, **characterised by the fact** that the light exit area (8) emerges from an edge associated with the card slot (1) of the visible surface (AS) of the housing upper part (AO) which faces the user.

## Revendications

1. Commutateur à carte avec une fente à carte (1) pour recevoir une carte (2) à insérer, composé d'un accessoire fonctionnel (A) qui est couplé électriquement et mécaniquement à un insert encastré (E) par au moins une partie de fiche (3) et au moins un ressort de serrage (4), **caractérisé en ce que** l'accessoire fonctionnel (A) se compose d'une partie de boîtier supérieure (AO) pourvue d'une fente à carte (1) et d'une partie de boîtier inférieure (AU) comprenant la partie de fiche (3) et les ressorts de serrage (4), dans lequel un dispositif de détection qui détecte la présence de la carte (2) est présent dans l'accessoire fonctionnel (A) et/ou dans l'insert encastré (E), et dans lequel des moyens de commutation (20) pour influencer au moins un actionneur connecté sont présents dans l'accessoire fonctionnel (A) et/ou dans l'insert encastré (E), et dans lequel des illuminants (5) sont présents dans l'accessoire fonctionnel (A) et/ou dans l'insert encastré (E), et dans lequel au moins un ensemble (7) en matériau transparent est inséré dans la partie supérieure (AO) du boîtier, dans lequel, d'une part, la lumière émise par les illuminants (5) est introduite et qui, d'autre part, sort avec sa zone de sortie de lumière (8) de la surface visible (AS) de la partie supérieure du boîtier (AO) tournée vers l'utilisateur, **caractérisé en ce qu'**une carte de circuit imprimé (6) équipée d'illuminants (5) est disposée dans la partie inférieure du boîtier (AU), et **en ce que** l'ensemble (7), qui prend en charge un guidage de carte, est disposé de manière à être maintenu entre une face avant de la carte de circuit imprimé (6), qui est tournée à l'opposé de la partie inférieure (AU) du boîtier, et une face arrière de la partie supérieure (AO) du boîtier, qui est tournée vers la partie inférieure (AU) du boîtier, et **en ce que** l'ensemble (7) est équipé d'au moins un élément à ressort (10), qui produit un effet haptique et qui coopère avec la carte (2) à insérer dans la fente (1) à carte.

2. Commutateur à carte selon la revendication 1, **caractérisé en ce que** l'ensemble (7) est construit en une seule pièce.

3. Commutateur à carte selon la revendication 1, **caractérisé en ce que** l'ensemble (7) est construit en plusieurs parties.

4. Commutateur à carte selon l'une des revendications 1 à 3, **caractérisé en ce que** l'ensemble (7) est constitué au moins partiellement de polycarbonate.

5. Commutateur à carte selon l'une des revendications 1 à 4, **caractérisé en ce que** l'ensemble (7) est constitué au moins partiellement de polyméthacrylate de méthyle.

6. Commutateur à carte selon l'une des revendications 1 à 5, **caractérisé en ce que** l'ensemble (7) est équipé d'éléments de verrouillage qui sont en liaison fonctionnelle avec la partie supérieure (AO) du boîtier de manière à la retenir.

7. Commutateur à carte selon l'une des revendications 1 à 6, **caractérisé en ce que** l'ensemble (7) est au moins partiellement pourvu d'une couche de laque opaque.

8. Commutateur à carte selon l'une des revendications 1 à 7, **caractérisé en ce que** la zone de sortie de la lumière (8) de l'ensemble (7) est au moins partiellement rectangulaire.

9. Commutateur à carte selon l'une des revendications 1 à 8, **caractérisé en ce que** la zone de sortie de la lumière (8) de l'ensemble (7) est au moins partiellement linéaire.

10. Commutateur à carte selon l'une des revendications 1 à 9, **caractérisé en ce que** la zone de sortie de la lumière (8) de l'ensemble (7) est au moins partiellement circulaire.

11. Commutateur à carte selon l'une des revendications 1 à 10, **caractérisé en ce que** la zone de sortie de la lumière (8) est pourvue d'au moins un élément de séparation constitué d'un matériau opaque.

12. Commutateur à carte selon l'une des revendications 1 à 11, **caractérisé en ce que** la carte de circuit imprimé (6) munie des illuminants (5) est en liaison fonctionnelle avec la partie supérieure (AO) du boîtier de manière à se verrouiller.

13. Commutateur à carte selon l'une des revendications 1 à 12, **caractérisé en ce que** les composants (18, 19) du dispositif de détection pour la reconnaissance de la carte (2) qui sont nécessaires au fonctionnement sont disposés sur la carte de circuit imprimé (6) fixée à la partie supérieure (AO) du boîtier.

14. Commutateur à carte selon l'une des revendications 1 à 13, **caractérisé en ce que** le dispositif de détection basé sur la technologie RFID pour l'identification de la carte (2) interagit avec la carte (2) en termes de technologie des données.

15. Commutateur à carte selon l'une des revendications 1 à 14, **caractérisé en ce que** la zone de sortie de lumière (8) émerge de la surface visible (AS) de la partie supérieure du boîtier (AO) tournée vers l'utilisateur, juste en dessous de la fente de carte (1) située dans la partie supérieure du boîtier (AO).

16. Commutateur à carte selon l'une des revendications 1 à 14, **caractérisé en ce que** la zone de sortie de lumière (8) émerge d'une zone de bord, associée à la fente de carte (1), de la surface visible (AS) de la partie supérieure du boîtier (AO) qui fait face à l'utilisateur.
